# EUROPEAN PATENT APPLICATION

(11) **EP 4 571 527 A1**
(43) Date of publication of application: **18.06.2025**
(21) Application number: 24191700.4
(22) Date of filing: 30.07.2024
(51) Int. Cl.: G06F 15/78, G11C 5/02

(54) **COMPUTING-IN-MEMORY CHIP ARCHITECTURE, PACKAGING METHOD, AND APPARATUS**

(30) Priority: 13.12.2023 CN 202311718033
(71) Applicant: Hangzhou Zhicun (Witmem) Technology Co., Ltd., Hangzhou, Zhejiang 311100 (CN)
(72) Inventor: SUN, Xuguang, Hangzhou, Zhejiang 311100 (CN); GUO, Xinjie, Hangzhou, Zhejiang 311100 (CN); TIAN, Yu, Hangzhou, Zhejiang 311100 (CN)
(74) Representative: Lucke, Andreas

(57) **Abstract**

The present disclosure relates to a computing-in-memory chip architecture, a packaging method for a computing-in-memory chip, and an apparatus. The computing-in-memory chip architecture includes: one or more first chips each integrated with one or more arrays of computing-in-memory cells of the computing-in-memory chip that are used to compute the received data; a second chip, on a first side of which a peripheral analog circuit IP core and a digital circuit IP core of the computing-in-memory chip are integrated; and an interface module configured to communicatively couple the second chip to each first chip, where the interface module includes one or more first sub-interface modules on each first chip and aligned with each other, and one or more second sub-interface modules integrated on a second side, opposite to the first side, of the second chip and aligned with the one or more first sub-interface modules on each first chip, and where a communication path between the second chip and each first chip is integrated on the second side of the second chip.

## Description

### TECHNICAL FIELD

The present disclosure relates to the technical field of computing-in-memory chips, and in particular, to a computing-in-memory chip architecture, a packaging method for a computing-in-memory chip, and an apparatus.

### BACKGROUND

The von Neumann architecture on which computers typically operate includes two separate parts, namely, a memory and a processor. When instructions are executed, data needs to be written to the memory, instructions and data are read from the memory in sequence via the processor, and finally execution results are written back to the memory. Accordingly, data is frequently transferred between the processor and the memory. If a transfer speed of the memory cannot match an operating speed of the processor, the computing power of the processor may be limited. For example, it takes 1 ns for the processor to execute an instruction, while it takes 10 ns for the instruction to be read and transferred from the memory. This significantly reduces the operating speed of the processor, and thus reduces the performance of the entire computing system.

Methods described in this section are not necessarily methods that have been previously conceived or employed. It should not be assumed that any of the methods described in this section is considered to be the prior art because it is included in this section, unless otherwise indicated expressly. Similarly, the problem mentioned in this section should not be considered to be recognized in any prior art, unless otherwise indicated expressly.

### SUMMARY

According to a first aspect of the present disclosure, a computing-in-memory chip architecture is provided. The computing-in-memory chip architecture includes: one or more first chips each integrated with one or more arrays of computing-in-memory cells of a computing-in-memory chip, where the one or more arrays of computing-in-memory cells are used to compute the received data; a second chip, on a first side of which a peripheral analog circuit IP core and a digital circuit IP core of the computing-in-memory chip are integrated; and an interface module configured to communicatively couple the second chip to each first chip, where the interface module includes one or more first sub-interface modules on each first chip and aligned with each other, and one or more second sub-interface modules integrated on a second side, opposite to the first side, of the second chip and aligned with the one or more first sub-interface modules on each first chip, and where a communication path between the second chip and each first chip is integrated on the second side of the second chip.

According to a second aspect of the present disclosure, a packaging method for a computing-in-memory chip is provided. The packaging method includes: integrating one or more arrays of computing-in-memory cells of the computing-in-memory chip on one or more first chips, where the one or more arrays of computing-in-memory cells are used to compute the received data; integrating a peripheral analog circuit IP core and a digital circuit IP core of the computing-in-memory chip on a first side of a second chip; and packaging the one or more first chips and the second chip, where each of the one or more first chips and the second chip are communicatively coupled to each other via an interface module, where the interface module includes one or more first sub-interface modules on each first chip and aligned with each other, and one or more second sub-interface modules integrated on a second side, opposite to the first side, of the second chip and aligned with the one or more first sub-interface modules on each first chip, and where a communication path between the second chip and each first chip is integrated on the second side of the second chip.

According to a third aspect of the present disclosure, an apparatus is provided, which includes the computing-in-memory chip architecture described above.

According to one or more embodiments of the present disclosure, by integrating the peripheral analog circuit IP core and the digital circuit IP core on one side of a chip and integrating communication paths on the other side of the chip, the chip may be fully utilized, and the number of chips may be significantly reduced, thereby further reducing production costs.

According to one or more other embodiments of the present disclosure, since the production processes and yields of different chips may be different, the method may also facilitate yield improvement and fault detection of computing-in-memory chip packages.

These and other aspects of the present disclosure will be clear from the embodiments described below and will be clarified with reference to the embodiments described below.

### BRIEF DESCRIPTION OF THE DRAWINGS

More details, features, and advantages of the present disclosure are disclosed in the following description of exemplary embodiments with reference to the accompanying drawings, in which:
FIG. 1 is a schematic diagram of a computing-in-memory chip architecture according to some embodiments of the present disclosure;
FIG. 2 is a schematic diagram of a second chip in a computing-in-memory chip architecture according to some embodiments of the present disclosure;
FIG. 3 is a flow chart of a packaging method for a computing-in-memory chip according to some embodiments of the present disclosure;
FIG. 4 is a flow chart of a packaging method for a computing-in-memory chip according to some other embodiments of the present disclosure; and
FIG. 5 is a flow chart of a packaging method for a computing-in-memory chip according to yet other embodiments of the present disclosure.

### DETAILED DESCRIPTION OF EMBODIMENTS

It is noted that although terms such as first, second and third may be used herein to describe various elements, components, areas, layers and/or parts, these elements, components, areas, layers and/or parts should not be limited by these terms. These terms are merely used to distinguish one element, component, area, layer or part from another. Therefore, a first element, component, area, layer or part discussed below may be referred to as a second element, component, area, layer or part without departing from the teaching of the present disclosure.

Terms regarding spatial relativity such as "under", "below", "lower", "beneath", "above" and "upper" may be used herein to describe the relationship between one element or feature and another element(s) or feature(s) as illustrated in the figures. It is noted that these terms are intended to cover different orientations of a device in use or operation in addition to the orientations depicted in the figures. For example, if the device in the figures is turned over, an element described as being "below other elements or features" or "under other elements or features" or "beneath other elements or features" will be oriented to be "above other elements or features". Thus, the exemplary terms "below" and "beneath" may cover both orientations "above" and "below". Terms such as "before" or "ahead" and "after" or "then" may similarly be used, for example, to indicate the order in which light passes through elements. The device may be oriented in other ways (rotated by 90° or in other orientations), and the spatially relative descriptors used herein are interpreted correspondingly. In addition, it will also be understood that when a layer is referred to as being "between two layers", it may be the only layer between the two layers, or there may also be one or more intermediate layers.

The terms used herein are merely for the purpose of describing specific embodiments and are not intended to limit the present disclosure. As used herein, the singular forms "a", "an", and "the" are intended to include plural forms as well, unless otherwise explicitly indicated in the context. Further, it is noted that the terms "comprise" and/or "include", when used in the description, specify the presence of described features, entireties, steps, operations, elements and/or components, but do not exclude the presence or addition of one or more other features, entireties, steps, operations, elements, components and/or groups thereof. As used herein, the term "and/or" includes any and all combinations of one or more of the associated listed items, and the phrase "at least one of A and B" refers to only A, only B, or both A and B.

It is noted that when an element or a layer is referred to as being "on another element or layer", "connected to another element or layer", "coupled to another element or layer", or "adjacent to another element or layer", the element or layer may be directly on another element or layer, directly connected to another element or layer, directly coupled to another element or layer, or directly adjacent to another element or layer, or there may be an intermediate element or layer. On the contrary, when an element is referred to as being "directly on another element or layer", "directly connected to another element or layer", "directly coupled to another element or layer", or "directly adjacent to another element or layer", there is no intermediate element or layer. However, under no circumstances should "on" or "directly on" be interpreted as requiring one layer to completely cover the underlying layer.

Embodiments of the present disclosure are described herein with reference to schematic illustrations (and intermediate structures) of idealized embodiments of the present disclosure. On this basis, variations in an illustrated shape, for example as a result of manufacturing techniques and/or tolerances, should be expected. Therefore, the embodiments of the present disclosure should not be interpreted as being limited to a specific shape of an area illustrated herein, but should comprise shape deviations caused due to manufacturing, for example. Therefore, the area illustrated in a figure is schematic, and the shape thereof is neither intended to illustrate the actual shape of the area of a device, nor to limit the scope of the present disclosure.

Unless otherwise defined, all terms (including technical and scientific terms) used herein have the same meanings as commonly understood by those of ordinary skill in the art to which the present disclosure belongs. It is further noted that the terms such as those defined in dictionaries should be interpreted as having meanings consistent with the meanings thereof in relevant fields and/or in the context of the description and will not be interpreted in an ideal or too formal sense, unless defined explicitly herein.

The von Neumann architecture on which computers typically operate includes two separate parts, namely, a memory and a processor. When instructions are executed, data needs to be written to the memory, instructions and data are read from the memory in sequence via the processor, and finally execution results are written back to the memory. Accordingly, data is frequently transferred between the processor and the memory. If a transfer speed of the memory cannot match an operating speed of the processor, the computing power of the processor may be limited, and thus the performance of the entire computing system is reduced.

To improve the computing power of the processor and alleviate the above problem, computing-in-memory chips have been rapidly developed. Such chips have a computing unit with computing power embedded into a memory. Control of an operating mode of the computing-in-memory chip may allow both data computation and data storage in the chip. Since there is no need to frequently transfer data between the processor and the memory, data transfer latency and power consumption can be reduced, and the performance of the entire computing system can be improved.

The inventors notice that such computing-in-memory chips usually include a computing unit with a computing function, a unit for processing and storing computed data, etc. The computing unit is usually implemented based on an analog circuit and has low requirements for a process node, while other units are mainly implemented based on a digital circuit and have high requirements for a process node. Currently, such computing-in-memory chips are mainly integrated by integrating the computing unit and the other units on different chips. In this context, if the computing unit performs excessive data computations, in order to improve the communication rate and transfer efficiency between chips, an interposer may be provided between the chips to achieve high-speed reading and writing of data in the computing unit. However, provision of an additional interposer (e.g., on which a dynamic random-access memory (DRAM) or a NAND memory is integrated) will increase the number of chips, thereby increasing production costs.

In view of the above technical problems, one or more embodiments of the present disclosure provide a computing-in-memory chip architecture, a packaging method for a computing-in-memory chip, and an apparatus. Various embodiments of the present disclosure are described in detail below in conjunction with the drawings.

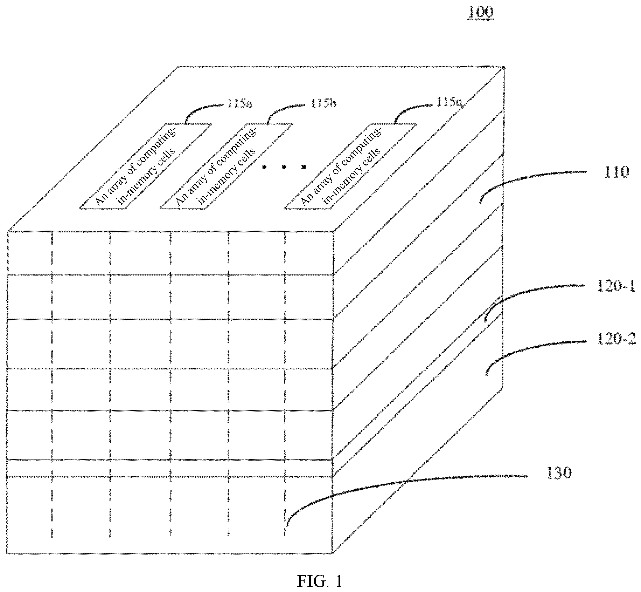

FIG. 1 is a schematic diagram of a computing-in-memory chip architecture 100 according to some embodiments of the present disclosure. As shown in FIG. 1, the computing-in-memory chip architecture 100 may include: one or more first chips 110 each integrated with one or more arrays of computing-in-memory cells 115a to 115n of a computing-in-memory chip, where the one or more arrays of computing-in-memory cells are used to compute the received data; a second chip 120, on a first side 120-1 of which a peripheral analog circuit IP core and a digital circuit IP core of the computing-in-memory chip are integrated; and an interface module 130 configured to communicatively couple the second chip 120 to each first chip 110, where the interface module 130 includes one or more first sub-interface modules on each first chip 110 and aligned with each other, and one or more second sub-interface modules integrated on a second side 120-2, opposite to the first side 120-1, of the second chip 120 and aligned with the one or more first sub-interface modules on each first chip 110, and where a communication path between the second chip 120 and each first chip 110 is integrated on the second side 120-2 of the second chip 120.

It is noted that the computing-in-memory chip architecture may refer to a computing-in-memory chip interconnection integrated structure, a computing-in-memory chip product, etc.

By integrating the peripheral analog circuit IP core and the digital circuit IP core on one side of a chip and integrating communication paths on the other side of the chip, the chip may be fully utilized, and the number of chips may be significantly reduced, thereby further reducing production costs. In addition, since the production processes and yields of different chips may be different, the method may also facilitate yield improvement and fault detection of computing-in-memory chip packages.

According to some embodiments of the present disclosure, the arrays of computing-in-memory cells on the first chips 110 may be implemented based on an analog circuit, that is, used for computing the received analog data, e.g., for computing a voltage and a current according to Kirchhoff s law or Ohm's law, various addition operations, multiplication operations, matrix multiplication operations, etc. It is noted that the arrays of computing-in-memory cells on the first chip 110 may be implemented based on a digital circuit. It should be also noted that although n arrays of computing-in-memory cells are shown in FIG. 1, the computing-in-memory chip may also include only one array of computing-in-memory cells.

According to some embodiments of the present disclosure, the peripheral analog circuit IP core 122 integrated on the second chip 120 is a functional module based on an analog signal. In some examples, the peripheral analog circuit IP core 122 may include one or more of: a programming circuit module coupled to the one or more arrays of computing-in-memory cells and configured to perform data programming on the one or more arrays of computing-in-memory cells; a digital-to-analog conversion module coupled to the one or more arrays of computing-in-memory cells and configured to convert digital data to be input to the one or more arrays of computing-in-memory cells into analog data; an analog-to-digital conversion module coupled to the one or more arrays of computing-in-memory cells and configured to convert analog data computed by the one or more arrays of computing-in-memory cells into digital data; a phase-locked loop; and an oscillator.

In some other examples, the peripheral analog circuit IP core may further include, for example, an input interface module, an input register file, an output register file, and an output interface module.

In still other examples, the peripheral analog circuit IP core may further include a calibration module for calibrating data obtained by the one or more arrays of computing-in-memory cells; and a compensation module for performing signal compensation on the data obtained by the one or more arrays of computing-in-memory cells. The use of the calibration module and the compensation module may further increase the accuracy of the chips, thereby effectively mitigating the interference of data transfer between different chips.

According to some embodiments of the present disclosure, the digital circuit IP core 124 integrated on the second chip 120 is a functional module based on a digital signal. In some examples, the digital circuit IP core 124 may include one or more of: a post-processing operation circuit configured to perform a post-processing operation on the digital data converted by the analog-to-digital conversion module; a random-access memory (RAM); a central processing unit (CPU); a graphics processing unit (GPU); and a peripheral interface module.

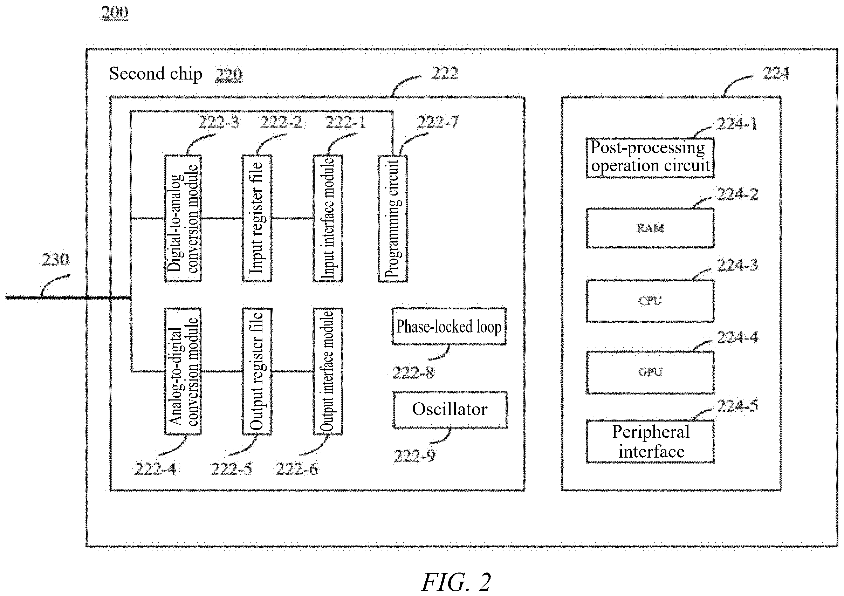

The modules of the peripheral analog circuit IP core and the digital circuit IP core will be described in detail below with reference to FIG. 2.

According to some embodiments of the present disclosure, the interface module 130 may be configured to transfer data between each first chip 110 and the second chip 120 through an analog signal.

When the computing unit and the other units are integrated on different chips, information is usually transferred between the chips through a digital signal, resulting in a high transfer power consumption. For example, transfer of data that is 8-bit wide requires eight digital signals, but only one analog signal. Therefore, the use of the analog signal to transfer data between each first chip and the second chip may significantly reduce the number of signals required for data transfer, thereby effectively reducing the power consumption.

According to some embodiments of the present disclosure, the interface module 130 may be an electrical interconnect between the first chip and the second chip. For example, the electrical interconnect may be a metal pin on the first chip and the second chip. According to some other embodiments of the present disclosure, the interface module 130 may also be a bus through which signals are transferred between the first chip and the second chip. According to still other embodiments of the present disclosure, the interface module 130 may include a through-silicon via (TSV) structure.

FIG. 2 illustrates a schematic diagram of a second chip 220 of a computing-in-memory chip architecture 200 according to some embodiments of the present disclosure. For the purpose of simplicity, FIG. 2 illustrates only the second chip 220 and an interface module 230. It is noted that the computing-in-memory chip architecture 200 may further include one or more first chips (including arrays of computing-in-memory cells) similar to those in the computing-in-memory chip architecture 100 described with reference to FIG. 1. For the purpose of simplicity, features, operations, and functions of the similar components are omitted.

As shown in FIG. 2, a peripheral analog circuit IP core 222 in the computing-in-memory chip architecture 200 may include: an input interface module 222-1 for receiving data to be processed; an input register file 222-2 coupled to the input interface module 222-1 and configured to register the data to be processed from the input interface module; a digital-to-analog conversion module 222-3 coupled to one or more arrays of computing-in-memory cells of the first chip and the input register file 222-2, and configured to convert digital data to be processed from the input interface module 222-1 into analog data; an analog-to-digital conversion module 222-4 also coupled to the one or more arrays of computing-in-memory cells of the first chip, and configured to convert analog data obtained by processing via the arrays of computing-in-memory cells into digital data; an output register file 222-5 coupled to the analog-to-digital conversion module 222-4 and configured to register digital data converted from the analog data obtained by processing via the one or more arrays of computing-in-memory cells; an output interface module 222-6 coupled to the output register file 222-5 and configured to output the registered digital data; a programming circuit 222-7 coupled to the one or more arrays of computing-in-memory cells of the first chip, which, in some examples, may include a voltage generation circuit and a voltage control circuit, so as to perform data programming on the one or more arrays of computing-in-memory cells of the first chip by controlling a voltage; a phase-locked loop 222-8 for providing a synchronized clock signal; and an oscillator 222-9 for generating a stable signal with a specific frequency.

Still referring to FIG. 2, a digital circuit IP core 224 in the computing-in-memory chip architecture 200 may include: a post-processing operation circuit 224-1 configured to, for example, perform post-processing operations such as shifting or activation on the digital data obtained by the analog-to-digital conversion module 222-4; a random-access memory (RAM) 224-2; a central processing unit (CPU) 224-3; a graphics processing unit (GPU) 224-4; and a peripheral interface 224-5.

It is noted that FIG. 2 illustrates one implementation of the peripheral analog circuit IP core and the digital circuit IP core in the computing-in-memory chip architecture for illustrative purposes only. The peripheral analog circuit IP core may further include one or more other modules, such as an analog data preprocessing module, and the digital circuit IP core may also include one or more other modules, such as a codec module. In addition, although FIG. 2 illustrates coupling manners between the modules included in the peripheral analog circuit IP core and the digital circuit IP core, it is understood that these modules may also be coupled in any other manner. The scope of protection of the present disclosure is not limited in this respect.

According to some embodiments of the present disclosure, the peripheral analog circuit IP core may include one or more modules, and the second chip may include one or more sub-chips each integrated with any of the one or more modules or a combination thereof.

In some examples, different modules in each peripheral analog circuit IP core may have different requirements for a chip process node. In this case, integration of different modules or a combination thereof in the peripheral analog circuit IP core on different chips makes it possible to select an appropriate process node for different modules in the peripheral analog circuit IP core. For example, the analog-to-digital conversion module and the digital-to-analog conversion module can be integrated on one chip through a process node with a relatively large line width, while the programming circuit can be integrated on another chip through a process node with a relatively small line width. In this way, the performance of the chips can be ensured, and the cost can be reduced. In addition, as described above, this also facilitates yield improvement and fault detection of the chips.

Although the above embodiments only describe integration of any one or a combination of the digital-to-analog conversion module, the analog-to-digital conversion module, and the programming circuit module on different sub-chips of the second chip, it is understood that, in a case that the peripheral analog circuit IP core of the computing-in-memory chip includes the input interface module, the input register file, the output register file, the output interface module, as described above, and any other optional modules, any one or a combination of these modules may also be integrated on different sub-chips.

According to some other embodiments of the present disclosure, the digital circuit IP core may also include one or more modules, and the second chip may include one or more sub-chips each integrated with any one of the one or more modules or a combination thereof.

Similarly, in some examples, different modules in each digital circuit IP core may have different requirements for a chip process node. In this case, integration of different modules or a combination thereof in the digital circuit IP core on different chips makes it possible to select an appropriate process node for each of the different modules in the digital circuit IP core. For example, the post-processing operation circuit can be integrated on one chip through a process node with a relatively large line width, while the CPU, the GPU, etc. can be integrated on another chip through a process node with a relatively small line width. In this way, the performance of the chips can be ensured, and the cost can be reduced. In addition, as described above, this also facilitates yield improvement and fault detection of the chips.

Although the above embodiments only describe integration of any one or a combination of the post-processing operation circuit, the CPU, and the GPU on different sub-chips of the second chip, it is understood that, in a case that the digital circuit IP core of the computing-in-memory chip includes the RAM, the peripheral interface module, as described above, and any other modules, any one or a combination of these modules may also be integrated on different sub-chips.

According to some embodiments of the present disclosure, the one or more arrays of computing-in-memory cells may be integrated on each first chip through a first process node, and the peripheral analog circuit IP core and the digital circuit IP core may be integrated, through a second process node different from the first process node, on the second chip.

In some examples, the arrays of computing-in-memory cells may be implemented based on an analog circuit. Since analog signals in analog circuits are susceptible to noise interference, integration of the arrays of computing-in-memory cells, and the peripheral analog circuit IP core and the digital circuit IP core on different chips through different process nodes may effectively mitigate the interference between these modules and ensure the accuracy and credibility of data. In addition, based on different implementations of two types of circuits, more appropriate process nodes may be selected, thereby reducing process costs.

According to some embodiments of the present disclosure, the line width of the second process node for integrating the peripheral analog circuit IP core and the digital circuit IP core may be less than that of the first process node for integrating the arrays of one or more computing-in-memory cells.

In some examples, the peripheral analog circuit IP core and the digital circuit IP core may be integrated on the second chip through a process node with a line width of 14 nanometers (nm) or 7 nm.

In other examples, the arrays of one or more computing-in-memory cells may be integrated on the first chip through a process node with a line width of 55 nm, 40 nm, or 28 nm.

In general, an implementation of chip based on an analog circuit has low requirements for a process node, because the use of an advanced process node with a smaller line width may cause distortion of the analog signal due to noise and reduce the accuracy. By contrast, an implementation of chip based on a digital circuit usually has high requirements for a process node, so as to improve the operating performance and accuracy of a chip. Therefore, the use of the process node with a smaller line width to integrate the peripheral analog circuit IP core and the digital circuit IP core, and the use of the process node with a larger line width to integrate the arrays of one or more computing-in-memory cells based on an analog circuit makes it possible to avoid high cost, excessive power consumption, and possible data distortion resulting from all using the advanced process nodes with a smaller line width to integrate different chips, and to avoid low operating performance of chips resulting from all using the process nodes with a larger line width to integrate different chips. This allows for a trade-off between performance, power consumption, and cost.

It is noted that the line widths of the first process node and the second process node can be selected based on actual scenarios. For example, the line width of the second process node may be greater than or equal to that of the first process node.

According to some embodiments of the present disclosure, the one or more arrays of computing-in-memory cells and the peripheral analog circuit IP core and the digital circuit IP core, and the DRAM may be integrated, through a same process node, on the one or more first chips and the second chip, respectively.

In this case, a more appropriate process node can be selected as needed. For example, when requirements for chip performance are not high and reduction of the power consumption and cost is desired, a process node with a line width of 28 nm can be selected to integrate the one or more arrays of computing-in-memory cells and the peripheral analog circuit IP core and the digital circuit IP core on the first chip and the second chip, respectively. For another example, if high chip performance is desired, a process node with a line width lower than 28 nm can be selected to integrate the one or more arrays of computing-in-memory cells and the peripheral analog circuit IP core and the digital circuit IP core on the first chip and the second chip, respectively.

The use of the same process node (that is, the same line width) to integrate different chips may simplify operations required to integrate the chips and their complexity.

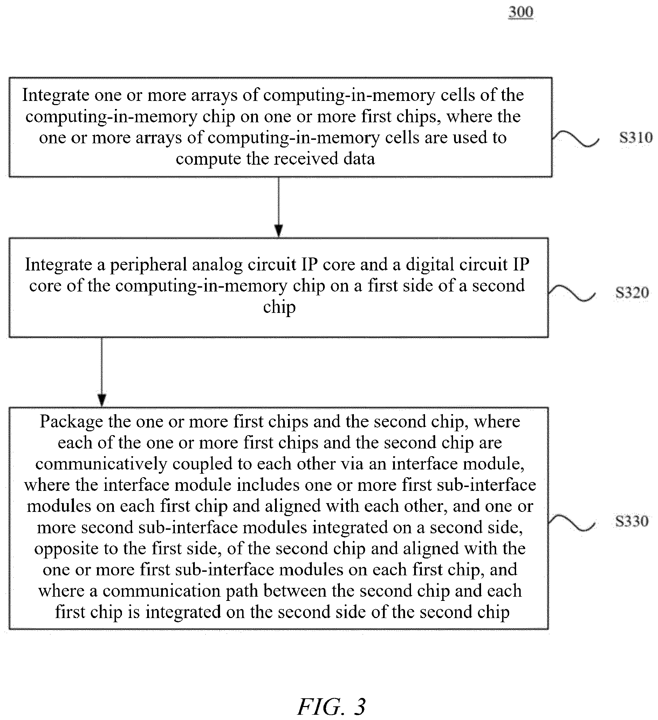

FIG. 3 illustrates a flow chart of a packaging method 300 for a computing-in-memory chip according to some embodiments of the present disclosure. As shown in FIG. 3, the packaging method 300 may include: step S310: integrating one or more arrays of computing-in-memory cells of the computing-in-memory chip on one or more first chips, where the one or more arrays of computing-in-memory cells are used to compute the received data; step S320: integrating a peripheral analog circuit IP core and a digital circuit IP core of the computing-in-memory chip on a first side of a second chip; and step S330: packaging the one or more first chips and the second chip, where each of the one or more first chips and the second chip are communicatively coupled to each other via an interface module, where the interface module includes one or more first sub-interface modules on each first chip and aligned with each other, and one or more second sub-interface modules integrated on a second side, opposite to the first side, of the second chip and aligned with the one or more first sub-interface modules on each first chip, and where a communication path between the second chip and each first chip is integrated on the second side of the second chip.

By integrating the peripheral analog circuit IP core and the digital circuit IP core on one side of a chip and integrating communication paths on the other side of the chip, the chip may be fully utilized, and the number of chips may be significantly reduced, thereby further reducing production costs. In addition, since the production processes and yields of different chips may be different, the method may also facilitate yield improvement and fault detection of computing-in-memory chip packages.

According to some embodiments of the present disclosure, step S310 of integrating the one or more arrays of computing-in-memory cells of the computing-in-memory chip on the one or more first chips may include: integrating, through a first process node, the one or more arrays of computing-in-memory cells on the one or more first chips; and step S320 of integrating the peripheral analog circuit IP core and the digital circuit IP core of the computing-in-memory chip on the first side of the second chip may include: integrating, through a second process node different from the first process node, the peripheral analog circuit IP core and the digital circuit IP core on the first side of the second chip.

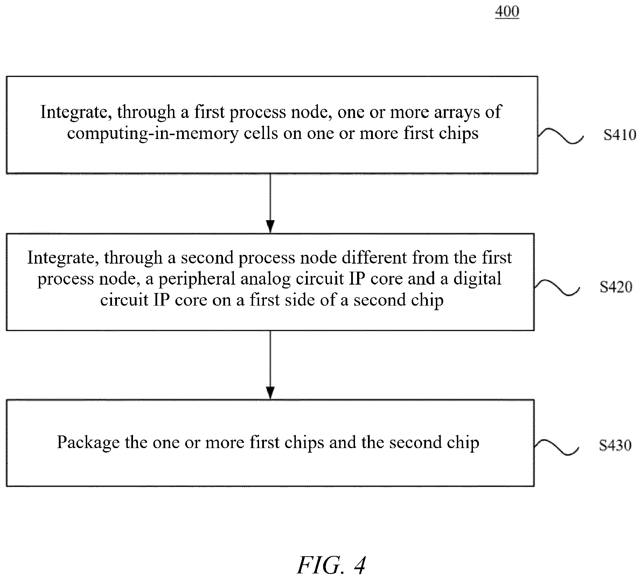

FIG. 4 illustrates a flow chart of a packaging method 400 for a computing-in-memory chip according to such embodiments of the present disclosure. As shown in FIG. 4, the packaging method 400 may include: step S410: integrating, through a first process node, one or more arrays of computing-in-memory cells on one or more first chips; step S420: integrating, through a second process node different from the first process node, a peripheral analog circuit IP core and a digital circuit IP core on a first side of a second chip; and step S430, which is similar to step S330 in FIG. 3: packaging the one or more first chips and the second chip.

By integrating, through different process nodes, the arrays of computing-in-memory cells and the peripheral analog circuit IP core and the digital circuit IP core on different chips, interference between the arrays of computing-in-memory cells and the peripheral analog circuit IP core and the digital circuit IP core may be effectively mitigated, and the accuracy and credibility of data may be ensured. In addition, based on different implementations of the two types of circuits, more appropriate process nodes may be selected, thereby reducing process costs.

According to some embodiments of the present disclosure, the line width of the second process node may be less than that of the first process node.

According to some embodiments of the present disclosure, the one or more arrays of computing-in-memory cells and the peripheral analog circuit IP core and the digital circuit IP core are integrated, through a same process node, on the one or more first chips and the second chip, respectively.

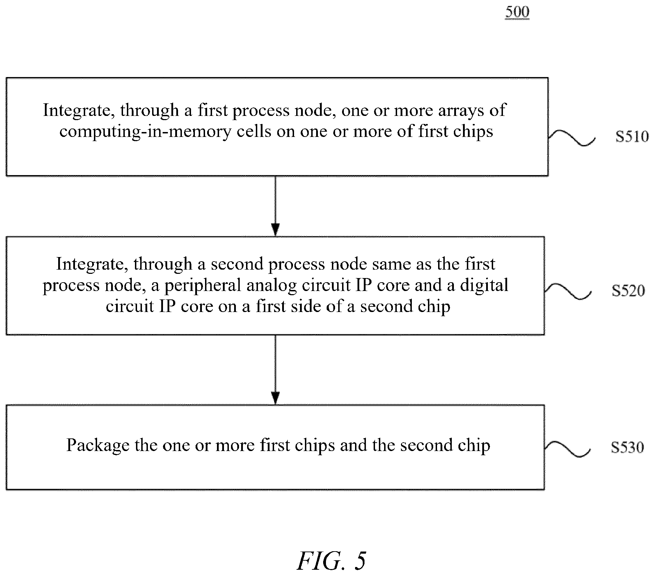

FIG. 5 illustrates a flow chart of a packaging method 500 for a computing-in-memory chip according to such embodiments of the present disclosure. As shown in FIG. 5, the packaging method 500 may include: step S510: integrating, through a first process node, one or more arrays of computing-in-memory cells on one or more of first chips; step S520: integrating, through a second process node same as the first process node, a peripheral analog circuit IP core and a digital circuit IP core on a first side of a second chip; and step S530, which is similar to step S330 in FIG. 3 and step S430 in FIG. 4: packaging the one or more first chips and the second chip.

As described above, in this case, a more appropriate process node can be selected as needed, and operations required to integrate the chips and their complexity can be simplified.

According to some embodiments of the present disclosure, the interface module may be configured to transfer data between each first chip and the second chip through an analog signal.

According to some embodiments of the present disclosure, the interface module may include a through-silicon via (TSV) structure.

According to some embodiments of the present disclosure, the peripheral analog circuit IP core may include one or more of: a programming circuit module coupled to the one or more arrays of computing-in-memory cells and configured to perform data programming on the one or more arrays of computing-in-memory cells; a digital-to-analog conversion module coupled to the one or more arrays of computing-in-memory cells and configured to convert digital data to be input to the one or more arrays of computing-in-memory cells into analog data; an analog-to-digital conversion module coupled to the one or more arrays of computing-in-memory cells and configured to convert analog data computed by the one or more arrays of computing-in-memory cells into digital data; a phase-locked loop; and an oscillator.

According to some embodiments of the present disclosure, the peripheral analog circuit IP core may include one or more modules, and the second chip may include one or more sub-chips each integrated with any of the one or more modules or a combination thereof.

According to some embodiments of the present disclosure, the digital circuit IP core may include one or more of: a post-processing operation circuit configured to perform a post-processing operation on the digital data converted by the analog-to-digital conversion module; a random-access memory (RAM); a central processing unit (CPU); a graphics processing unit (GPU); and a peripheral interface module.

According to some embodiments of the present disclosure, the digital circuit IP core may include one or more modules, and the second chip may include one or more sub-chips each integrated with any of the one or more modules or a combination thereof.

It is noted that the steps of the packaging methods 300-500 shown in FIGS. 3-5 may correspond to the modules in the computing-in-memory chip architectures 100-200 described with reference to FIGS. 1-2. Therefore, the components, functions, features, and advantages described above for the computing-in-memory chip architectures 100-200 are applicable to the packaging methods 300-500 and the steps included therein. For the purpose of brevity, some operations, features, and advantages are not described herein.

According to another aspect of the present disclosure, an apparatus is provided, which includes the computing-in-memory chip architecture described above.

Although the present disclosure has been illustrated and described in detail with reference to the accompanying drawings and the foregoing description, such illustration and description should be considered illustrative and schematic, rather than limiting; and the present disclosure is not limited to the disclosed embodiments. By studying the accompanying drawings, the disclosure, and the appended claims, those skilled in the art can understand and implement modifications to the disclosed embodiments when practicing the claimed subject matters. In the claims, the word "comprising" does not exclude other elements or steps not listed, the indefinite article "a" or "an" does not exclude plural, and the term "a plurality of' means two or more. The mere fact that certain measures are recited in different dependent claims does not indicate that a combination of these measures cannot be used to get benefit.

## Claims

1. A computing-in-memory chip architecture (100, 200), comprising:
one or more first chips (110) each integrated with one or more arrays of computing-in-memory cells (115a, 115b, 115n) of the computing-in-memory chip, wherein the one or more arrays of computing-in-memory cells are used to compute the received data;
a second chip (120, 220), on a first side (120-1) of which a peripheral analog circuit IP core (222) and a digital circuit IP core (224) of the computing-in-memory chip are integrated; and
an interface module (130, 230) configured to communicatively couple the second chip to each first chip,
wherein the interface module includes one or more first sub-interface modules on each first chip and aligned with each other, and one or more second sub-interface modules integrated on a second side (120-2), opposite to the first side, of the second chip and aligned with the one or more first sub-interface modules on each first chip, and
wherein a communication path between the second chip and each first chip is integrated on the second side of the second chip.

2. The computing-in-memory chip architecture according to claim 1, wherein the interface module includes a through-silicon via (TSV) structure.

3. The computing-in-memory chip architecture according to claim 1 or 2, wherein the peripheral analog circuit IP core (222) includes one or more of:
a programming circuit module (222-7) coupled to the one or more arrays of computing-in-memory cells and configured to perform data programming on the one or more arrays of computing-in-memory cells;
a digital-to-analog conversion module (222-3) coupled to the one or more arrays of computing-in-memory cells and configured to convert digital data to be input to the one or more arrays of computing-in-memory cells into analog data;
an analog-to-digital conversion module (222-4) coupled to the one or more arrays of computing-in-memory cells and configured to convert analog data computed by the one or more arrays of computing-in-memory cells into digital data;
a phase-locked loop (222-8); and
an oscillator (222-9).

4. The computing-in-memory chip architecture according to any one of the preceding claims, wherein the peripheral analog circuit IP core (222) includes one or more modules, and
wherein the second chip includes one or more sub-chips each integrated with any of the one or more modules or a combination thereof.

5. The computing-in-memory chip architecture according to claim 3, optionally in combination with claim 4, wherein the digital circuit IP core (224) comprises one or more of:
a post-processing operation circuit (224-1) configured to perform a post-processing operation on the digital data converted by the analog-to-digital conversion module;
a random-access memory (RAM) (224-2);
a central processing unit (CPU) (224-3);
a graphics processing unit (GPU) (224-4); and
a peripheral interface module (224-5).

6. The computing-in-memory chip architecture according to any one of the preceding claims, wherein the digital circuit IP core (224) comprises one or more modules, and
wherein the second chip includes one or more sub-chips each integrated with any of the one or more modules or a combination thereof.

7. The computing-in-memory chip architecture according to any of claims 1 to 6, wherein the one or more arrays of computing-in-memory cells are integrated, through a first process node, on each first chip, and the peripheral analog circuit IP core and the digital circuit IP core are integrated, through a second process node different from the first process node, on the second chip.

8. The computing-in-memory chip architecture according to claim 7, wherein a line width of the second process node is less than that of the first process node.

9. The computing-in-memory chip architecture according to any of claims 1 to 6, wherein the one or more arrays of computing-in-memory cells and the peripheral analog circuit IP core and the digital circuit IP core are integrated, through a same process node, on each first chip and the second chip, respectively.

10. A packaging method (300) for a computing-in-memory chip comprising:
integrating (S310) one or more arrays of computing-in-memory cells of the computing-in-memory chip on one or more first chips, wherein the one or more computing-in-memory cell arrays are used to compute the received data;
integrating (S320) a peripheral analog circuit IP core and a digital circuit IP core of the computing-in-memory chip on a first side of a second chip; and
packaging (S330) the one or more first chips and the second chip,
wherein each of the one or more first chips and the second chip are communicatively coupled to each other via an interface module,
wherein the interface module comprises one or more first sub-interface modules on each first chip and aligned with each other, and one or more second sub-interface modules integrated on a second side, opposite to the first side, of the second chip and aligned with the one or more first sub-interface modules on each first chip, and
wherein a communication path between the second chip and each first chip is integrated on the second side of the second chip.

11. The packaging method according to claim 10, wherein the interface module comprises a through-silicon via (TSV) structure, or
wherein the one or more arrays of computing-in-memory cells and the peripheral analog circuit IP core and the digital circuit IP core are integrated, through a same process node, on the one or more first chips and the second chip, respectively, or
wherein the peripheral analog circuit IP core includes one or more of:
a programming circuit module coupled to the one or more arrays of computing-in-memory cells and configured to perform data programming on the one or more arrays of computing-in-memory cells;
a digital-to-analog conversion module coupled to the one or more arrays of computing-in-memory cells and configured to convert digital data to be input to the one or more arrays of computing-in-memory cells into analog data;
an analog-to-digital conversion module coupled to the one or more arrays of computing-in-memory cells and configured to convert analog data computed by the one or more arrays of computing-in-memory cells into digital data;
a phase-locked loop; and
an oscillator.

12. The packaging method according to claim 10, wherein integrating the one or more arrays of computing-in-memory cells of the computing-in-memory chip on the one or more first chips includes: integrating, through a first process node, the one or more arrays of computing-in-memory cells on the one or more first chips; and
wherein integrating the peripheral analog circuit IP core and the digital circuit IP core of the computing-in-memory chip on the first side of the second chip includes: integrating, through a second process node different from the first process node, the peripheral analog circuit IP core and the digital circuit IP core on the first side of the second chip, and optionally
wherein a line width of the second process node is less than that of the first process node.

13. The packaging method according to claim 10 or 11, wherein the peripheral analog circuit IP core includes one or more modules, and wherein the second chip includes one or more sub-chips each integrated with any of the one or more modules or a combination thereof, or
wherein the digital circuit IP core includes one or more modules, and wherein the second chip includes one or more sub-chips each integrated with any of the one or more modules or a combination thereof.

14. The packaging method according to claim 11, optionally in combination with claim 13, wherein the digital circuit IP core includes one or more of:
a post-processing operation circuit configured to perform a post-processing operation on the digital data converted by the analog-to-digital conversion module;
a random-access memory (RAM);
a central processing unit (CPU);
a graphics processing unit (GPU); and
a peripheral interface module.

15. An apparatus comprising the computing-in-memory chip architecture according to any of claims 1 to 9.
